# EUROPEAN PATENT APPLICATION

(11) **EP 4 027 325 A1**
(43) Date of publication of application: **13.07.2022**
(21) Application number: 20860036.1
(22) Date of filing: 14.07.2020
(51) Int. Cl.: G09G 3/20, G11C 19/28

(54) **GATE DRIVING CIRCUIT AND CONTROL METHOD THEREFOR, AND DISPLAY DEVICE**

(30) Priority: 05.09.2019 CN 201910835269
(71) Applicant: BOE Technology Group Co., Ltd., Beijing 100015 (CN); Hefei Boe Display Technology Co., Ltd., Hefei, Anhui 230012 (CN)
(72) Inventor: ZHANG, Yuntian, Beijing 100176 (CN); JIANG, Peng, Beijing 100176 (CN); YANG, Haipeng, Beijing 100176 (CN); DAI, Ke, Beijing 100176 (CN); ZHANG, Chunxu, Beijing 100176 (CN); WU, Zhonghou, Beijing 100176 (CN); TIAN, Li, Beijing 100176 (CN)
(74) Representative: Santarelli
(86) International application number: PCT/CN2020/101924
(87) International publication number: WO 2021/042873

(57) **Abstract**

A gate driving circuit. The gate driving circuit comprises: an input sub-circuit (110) configured to convert the potential of a first node (N1) from a first level to a second level under the control of a first input signal (S_{IN1}); an output sub-circuit (120) configured to output a gate driving signal (S_{OUT}) in response to a second input signal (S_{IN2}); a first reset sub-circuit (130) configured to reset the potential of the first node (N1) under the control of a first reset signal (S_{RST1}); at least one de-noising sub-circuit (140) configured to maintain the potentials of the first node (N1) and an output end of the output sub-circuit (120) at the first level in the case that the potential of the first ode (N1) is reset; and a function maintenance sub-circuit (150) configured to control the de-noising sub-circuit (140) to operate under the control of the first input signal (S_{IN1}) so that the de-noising sub-circuit (140) interrupts the first node (N1) and a first voltage end. Also provided are a control method for a gate driving circuit and a display device. The output of the gate driving signal of the gate driving circuit is not affected by characteristic drift of a switching transistor.

## Description

### CROSS-REFERENCE TO RELATED APPLICATIONS

The present application is based on and claims priority to China Patent Application No. 201910835269.4, filed on September 5, 2019, the disclosure of which is incorporated by reference herein in its entirety.

### TECHNICAL FIELD

The present disclosure relates to the field of display technology, and in particular to a gate driving circuit, a control method thereof, and a display device.

### BACKGROUND

The gate driving circuit (also referred to as GOA (Gate Driver on Array)) may implement a progressive scan driving method for the display panel. The gate driving circuit technology is used in various displays. At present, with the development of display technology, the gate driving circuit technology has also been greatly developed.

### SUMMARY

According to an aspect of embodiments of the present disclosure, a gate driving circuit is provided. The gate driving circuit comprises: an input sub-circuit electrically connected to a first node and configured to change a potential of the first node from a first level to a second level under control of a first input signal; an output sub-circuit electrically connected to the first node and configured to output a gate driving signal in response to a second input signal; a first reset sub-circuit configured to reset the potential of the first node under control of a first reset signal; at least one noise reduction sub-circuit electrically connected to the first node and a first voltage terminal for providing the first level, and configured to maintain the potential of the first node and a potential of an output terminal of the output sub-circuit at the first level in a case where the potential of the first node is reset; and a function maintaining sub-circuit electrically connected to the at least one noise reduction sub-circuit and the first voltage terminal, and configured to control operation of the at least one noise reduction sub-circuit under control of the first input signal, so that the at least one noise reduction sub-circuit interrupts electrical coupling between the first node and the first voltage terminal.

In some embodiments, the at least one noise reduction sub-circuit comprises a first noise reduction sub-circuit; and the function maintaining sub-circuit comprises a first switching transistor, wherein a first electrode of the first switching transistor is electrically connected to the first noise reduction sub-circuit, a second electrode of the first switching transistor is electrically connected to the first voltage terminal, and a gate of the first switching transistor is configured to receive the first input signal.

In some embodiments, the at least one noise reduction sub-circuit further comprises a second noise reduction sub-circuit; and the function maintaining sub-circuit further comprises a second switching transistor, wherein a first electrode of the second switching transistor is electrically connected to the second noise reduction sub-circuit, a second electrode of the second switching transistor is electrically connected to the first voltage terminal, and a gate of the second switching transistor is configured to receive the first input signal.

In some embodiments, the first noise reduction sub-circuit comprises: a third switching transistor, wherein a first electrode of the third switching transistor is electrically connected to a second voltage terminal, a second electrode of the third switching transistor is electrically connected to a second node, and a gate of the third switching transistor is electrically connected to a third node; a fourth switching transistor, wherein a first electrode and a gate of the fourth switching transistor are electrically connected to the second voltage terminal, and a second electrode of the fourth switching transistor is electrically connected to the third node; a fifth switching transistor, wherein a first electrode of the fifth switching transistor is electrically connected to the second node, a second electrode of the fifth switching transistor is electrically connected to the first voltage terminal, and a gate of the fifth switching transistor is electrically connected to the first node; a sixth switching transistor, wherein a first electrode of the sixth switching transistor is electrically connected to the third node, a second electrode of the sixth switching transistor is electrically connected to the first voltage terminal, and a gate of the sixth switching transistor is electrically connected to the first node; a seventh switching transistor, wherein a first electrode of the seventh switching transistor is electrically connected to the first node, a second electrode of the seventh switching transistor is electrically connected to the first voltage terminal, and a gate of the seventh switching transistor is electrically connected to the second node; and an eighth switching transistor, wherein a first electrode of the eighth switching transistor is electrically connected to the output terminal of the output sub-circuit, a second electrode of the eighth switching transistor is electrically connected to the first voltage terminal, and a gate of the eight switching transistor is electrically connected to the second node; wherein the first electrode of the first switching transistor is electrically connected to the second node.

In some embodiments, the second voltage terminal is configured to provide the second level.

In some embodiments, the second noise reduction sub-circuit comprises: a ninth switching transistor, wherein a first electrode of the ninth switching transistor is electrically connected to a third voltage terminal, a second electrode of the ninth switching transistor is electrically connected to a fourth node, and a gate of the ninth switching transistor is electrically connected to a fifth node; a tenth switching transistor, wherein a first electrode and a gate of the tenth switching transistor are electrically connected to the third voltage terminal, and a second electrode of the tenth switching transistor is electrically connected to the fifth node; an eleventh switching transistor, wherein a first electrode of the eleventh switching transistor is electrically connected to the fourth node, a second electrode of the eleventh switching transistor is electrically connected to the first voltage terminal, and a gate of the eleventh switching transistor is electrically connected to the first node; a twelfth switching transistor, wherein a first electrode of the twelfth switching transistor is electrically connected to the fifth node, a second electrode of the twelfth switching transistor is electrically connected to the first voltage terminal, and a gate of the twelfth switching transistor is electrically connected to the first node; a thirteenth switching transistor, wherein a first electrode of the thirteenth switching transistor is electrically connected to the first node, a second electrode of the thirteenth switching transistor is electrically connected to the first voltage terminal, and a gate of the thirteen switching transistor is electrically connected to the fourth node; and a fourteenth switching transistor, wherein a first electrode of the fourteenth switching transistor is electrically connected to the output terminal of the output sub-circuit, a second electrode of the fourteenth switching transistor is electrically connected to the first voltage terminal, and a gate of the fourteenth switching transistor is electrically connected to the fourth node; wherein the first electrode of the second switching transistor is electrically connected to the fourth node.

In some embodiments, the third voltage terminal is configured to provide the second level.

In some embodiments, the first reset sub-circuit comprises a fifteenth switching transistor, wherein a first electrode of the fifteenth switching transistor is electrically connected to the first node, a second electrode of the fifteenth switching transistor is electrically connected to the first voltage terminal, and a gate of the fifteenth switching transistor is configured to receive the first reset signal.

In some embodiments, the gate driving circuit further comprises a second reset sub-circuit configured to reset the potential of the output terminal of the output sub-circuit under control of a second reset signal.

In some embodiments, the second reset sub-circuit comprises a sixteenth switching transistor, wherein a first electrode of the sixteenth switching transistor is electrically connected to the output terminal of the output sub-circuit, a second electrode of the sixteenth switching transistor is electrically connected to the first voltage terminal, and a gate of the sixteenth switching transistor is configured to receive the second reset signal.

In some embodiments, the gate driving circuit further comprises a third reset sub-circuit configured to reset the potential of the first node under control of a global reset signal.

In some embodiments, the third reset sub-circuit comprises a seventeenth switching transistor, wherein a first electrode of the seventeenth switching transistor is electrically connected to the first node, a second electrode of the seventeenth switching transistor is electrically connected to the first voltage terminal, and a gate of the seventeen switching transistor is configured to receive the global reset signal.

In some embodiments, the input sub-circuit comprises an eighteenth switching transistor, wherein a first electrode and a gate of the eighteenth switching transistor are configured to receive the first input signal, and a second electrode of the eighteenth switching transistor is electrically connected to the first node.

In some embodiments, the output sub-circuit comprises: a nineteenth switching transistor, wherein a first electrode of the nineteenth switching transistor is configured to receive the second input signal, a second electrode of the nineteenth switching transistor is used as the output terminal of the output sub-circuit, and a gate of the nineteenth switching transistor is electrically connected to the first node; and a capacitor, wherein a first terminal of the capacitor is electrically connected to the first node, and a second terminal of the capacitor is electrically connected to the second electrode of the nineteenth switching transistor.

According to another aspect of embodiments of the present disclosure, a gate driving circuit is provided. The gate driving circuit comprises: a first switching transistor, wherein a first electrode of the first switching transistor is electrically connected to a second node, a second electrode of the first switching transistor is electrically connected to a first voltage terminal for providing a first level, and a gate of the first switching transistor is configured to receive a first input signal; a second switching transistor, wherein a first electrode of the second switching transistor is electrically connected to a fourth node, a second electrode of the second switching transistor is electrically connected to the first voltage terminal, and a gate of the second switching transistor is configured to receive the first input signal; a third switching transistor, wherein a first electrode of the third switching transistor is electrically connected to a second voltage terminal, a second electrode of the third switching transistor is electrically connected to the second node, and a gate of the third switching transistor is electrically connected to a third node; a fourth switching transistor, wherein a first electrode and a gate of the fourth switching transistor are electrically connected to the second voltage terminal, and a second electrode of the fourth switching transistor is electrically connected to the third node; a fifth switching transistor, wherein a first electrode of the fifth switching transistor is electrically connected to the second node, a second electrode of the fifth switching transistor is electrically connected to the first voltage terminal, and a gate of the fifth switching transistor is electrically connected to a first node; a sixth switching transistor, wherein a first electrode of the sixth switching transistor is electrically connected to the third node, a second electrode of the sixth switching transistor is electrically connected to the first voltage terminal, and a gate of the sixth switching transistor is electrically connected to the first node; a seventh switching transistor, wherein a first electrode of the seventh switching transistor is electrically connected to the first node, a second electrode of the seventh switching transistor is electrically connected to the first voltage terminal, and a gate of the seventh switching transistor is electrically connected to the second node; an eighth switching transistor, wherein a first electrode of the eighth switching transistor is electrically connected to an output terminal, a second electrode of the eighth switching transistor is electrically connected to the first voltage terminal, and a gate of the eighth switching transistor is electrically connected to the second node; a ninth switching transistor, wherein a first electrode of the ninth switching transistor is electrically connected to a third voltage terminal, a second electrode of the ninth switching transistor is electrically connected to the fourth node, and a gate of the ninth switching transistor is electrically connected to a fifth node; a tenth switching transistor, wherein a first electrode and a gate of the tenth switching transistor are electrically connected to the third voltage terminal, and a second electrode of the tenth switching transistor is electrically connected to the fifth node; an eleventh switching transistor, wherein a first electrode of the eleventh switching transistor is electrically connected to the fourth node, a second electrode of the eleventh switching transistor is electrically connected to the first voltage terminal, and a gate of the eleventh switching transistor is electrically connected to the first node; a twelfth switching transistor, wherein a first electrode of the twelfth switching transistor is electrically connected to the fifth node, a second electrode of the twelfth switching transistor is electrically connected to the first voltage terminal, and a gate of the twelfth switching transistor is electrically connected to the first node; a thirteenth switching transistor, wherein a first electrode of the thirteenth switching transistor is electrically connected to the first node, a second electrode of the thirteenth switching transistor is electrically connected to the first voltage terminal, and a gate of the thirteen switching transistor is electrically connected to the fourth node; a fourteenth switching transistor, wherein a first electrode of the fourteenth switching transistor is electrically connected to the output terminal, a second electrode of the fourteenth switching transistor is electrically connected to the first voltage terminal, and a gate of the fourteenth switching transistor is electrically connected to the fourth node; a fifteenth switching transistor, wherein a first electrode of the fifteenth switching transistor is electrically connected to the first node, a second electrode of the fifteenth switching transistor is electrically connected to the first voltage terminal, and a gate of the fifteenth switching transistor is configured to receive a first reset signal; a sixteenth switching transistor, wherein a first electrode of the sixteenth switching transistor is electrically connected to the output terminal, a second electrode of the sixteenth switching transistor is electrically connected to the first voltage terminal, and a gate of the sixteenth switching transistor is configured to receive a second reset signal; a seventeenth switching transistor, wherein a first electrode of the seventeenth switching transistor is electrically connected to the first node, a second electrode of the seventeenth switching transistor is electrically connected to the first voltage terminal, and a gate of the seventeen switching transistor is configured to receive a global reset signal; an eighteenth switching transistor, wherein a first electrode and a gate of the eighteenth switching transistor are configured to receive the first input signal, and a second electrode of the eighteenth switching transistor is electrically connected to the first node; a nineteenth switching transistor, wherein a first electrode of the nineteenth switching transistor is configured to receive a second input signal, a second electrode of the nineteenth switching transistor is used as the output terminal, and a gate of the nineteenth switching transistor is electrically connected to the first node; and a capacitor, wherein a first terminal of the capacitor is electrically connected to the first node, and a second terminal of the capacitor is electrically connected to the second electrode of the nineteenth switching transistor.

In some embodiments, the second voltage terminal is configured to provide a second level; and the third voltage terminal is configured to provide the second level.

According to another aspect of embodiments of the present disclosure, a display device is provided. The device comprises a plurality of gate driving circuits as described above.

In some embodiments, the plurality of gate driving circuits comprise N gate driving circuits, where N is a positive integer; in the N gate driving circuits, the gate driving signal output by an (i-k)-th gate driving circuit is used as the first input signal of an i-th gate driving circuit, the gate driving signal output by an (i+k+1)-th gate driving circuit is used as the first reset signal of the i-th gate driving circuit, and the gate driving signal output by an (i+k) -th gate driving circuit is used as the second reset signal of the i-th gate driving circuit, where k+1≤i≤N-k-1 and i is a positive integer, 1≤k≤N-2 and k is a positive integer; and in the N gate driving circuits, first input signals of first to k-th gate driving circuits are first input signals provided by an external circuit, first reset signals of (N-k) -th to N-th gate driving circuits are first reset signals provided by the external circuit, and second reset signals of (N-k+1) -th to N-th gate driving circuits are second reset signals provided by the external circuit.

According to another aspect of embodiments of the present disclosure, a control method for a gate driving circuit is provided. The control method comprises: changing a potential of a first node from a first level to a second level by an input sub-circuit under control of a first input signal; outputting a gate driving signal in response to a second input signal by an output sub-circuit; resetting a potential of an output terminal of the output sub-circuit by a second reset sub-circuit under control of a second reset signal; and resetting the potential of the first node by a first reset sub-circuit under control of a first reset signal, and maintaining the potential of the first node and the potential of the output terminal of the output sub-circuit at the first level by at least one noise reduction sub-circuit; wherein in the changing of the potential of the first node from the first level to the second level by the input sub-circuit, a function maintaining sub-circuit controls operation of the at least one noise reduction sub-circuit under control of the first input signal, so that the at least one noise reduction sub-circuit interrupts electrical coupling between the first node and a first voltage terminal.

Other features and advantages of the present disclosure will become apparent from the following detailed description of exemplary embodiments of the present disclosure with reference to the accompanying drawings.

### BRIEF DESCRIPTION OF THE DRAWINGS

The accompanying drawings, which constitute part of this specification, illustrate exemplary embodiments of the present disclosure and, together with this specification, serve to explain the principles of the present disclosure.

The present disclosure may be more clearly understood from the following detailed description with reference to the accompanying drawings, in which:
Fig. 1 is a schematic view showing the connection of a gate driving circuit according to an embodiment of the present disclosure;
Fig. 2 is a schematic view showing the connection of a gate driving circuit according to another embodiment of the present disclosure;
Fig. 3 is a schematic view showing an I-V characteristic curve of a switching transistor according to an embodiment of the present disclosure;
Fig. 4 is a schematic view showing the connection of a gate driving circuit according to another embodiment of the present disclosure;
Fig. 5 is a timing diagram showing control signals of a gate driving circuit according to an embodiment of the present disclosure;
Fig. 6 is a schematic view showing the connection of a gate driving circuit according to another embodiment of the present disclosure;
Fig. 7 is a schematic view showing the connection of a gate driving circuit according to another embodiment of the present disclosure;
Fig. 8 is a timing diagram showing control signals of a gate driving circuit according to another embodiment of the present disclosure;
Fig. 9 is a schematic view showing the cascade connection of gate driving circuits of a display device according to an embodiment of the present disclosure;
Fig. 10 is a flowchart showing a control method for a gate driving circuit according to an embodiment of the present disclosure.

It should be understood that the dimensions of the various parts shown in the accompanying drawings are not drawn according to the actual scale. In addition, the same or similar reference signs are used to denote the same or similar components.

### DETAILED DESCRIPTION

Various exemplary embodiments of the present disclosure will now be described in detail in conjunction with the accompanying drawings. The description of the exemplary embodiments is merely illustrative and is in no way intended as a limitation to the present disclosure, its application or use. The present disclosure may be implemented in many different forms, which are not limited to the embodiments described herein. These embodiments are provided to make the present disclosure thorough and complete, and fully convey the scope of the present disclosure to those skilled in the art. It should be noticed that: relative arrangement of components and steps, material composition, numerical expressions, and numerical values set forth in these embodiments, unless specifically stated otherwise, should be explained as merely illustrative, and not as a limitation.

The use of the terms "first", "second" and similar words in the present disclosure do not denote any order, quantity or importance, but are merely used to distinguish between different parts. A word such as "comprise", "include", or the like means that the element before the word covers the element (s) listed after the word without excluding the possibility of also covering other elements. The terms "up", "down", "left", "right", or the like are used only to represent a relative positional relationship, and the relative positional relationship may be changed correspondingly if the absolute position of the described object changes.

In the present disclosure, when it is described that a particular device is located between the first device and the second device, there may be an intermediate device between the particular device and the first device or the second device, and alternatively, there may be no intermediate device. When it is described that a particular device is connected to other devices, the particular device may be directly connected to said other devices without an intermediate device, and alternatively, may not be directly connected to said other devices but with an intermediate device.

All the terms (comprising technical and scientific terms) used in the present disclosure have the same meanings as understood by those skilled in the art of the present disclosure unless otherwise defined. It should also be understood that terms as defined in general dictionaries, unless explicitly defined herein, should be interpreted as having meanings that are consistent with their meanings in the context of the relevant art, and not to be interpreted in an idealized or extremely formalized sense.

Techniques, methods, and apparatus known to those of ordinary skill in the relevant art may not be discussed in detail, but where appropriate, these techniques, methods, and apparatuses should be considered as part of this specification.

In the related art, in addition to being output to a gate line located in the display area of the display panel, the gate driving signal output by a gate driving circuit may be output to other gate driving circuits as an input control signal of another gate driving circuit.

The inventors of the present disclosure have found that, an I-V characteristic curve of a switching transistor in an output sub-circuit of each of at least part of the gate driving circuits may drift to the right after a long time of operation of the switching transistor, resulting in a decrease in an output current during the operation of the switching transistor. Since an output terminal of the switching transistor is electrically connected to the gate line in the display area, which results in that the overall load thereof is very large, the output capability of the switching transistor is also reduced. When the switching transistor provides the input control signal to the other gate driving circuit, it may not provide enough current to pull up a potential of a pull-up node of the other gate driving circuit, thereby making it impossible to effectively pull down a potential of a pull-down node of the other gate driving circuit under the action of a power supply voltage signal. As a result, the potential of the pull-up node of the other gate driving circuit as well as an output signal cannot be effectively pulled up, thereby further reducing the output gate driving signal.

Since gate driving circuits are electrically connected in a cascade connection manner, the gate driving circuit of each stage may affect the output of the gate driving signal of the gate driving circuit in the next stage. Eventually, it is possible to result in that starting from a gate driving circuit in a certain row, the gate driving circuit cannot output a normal gate driving signal, which results in failure of the gate driving circuit.

In view of this, the embodiments of the present disclosure provide a gate driving circuit to prevent failure of the gate driving circuit as much as possible. The gate driving circuit according to some embodiments of the present disclosure will be described in detail below in conjunction with the accompanying drawings.

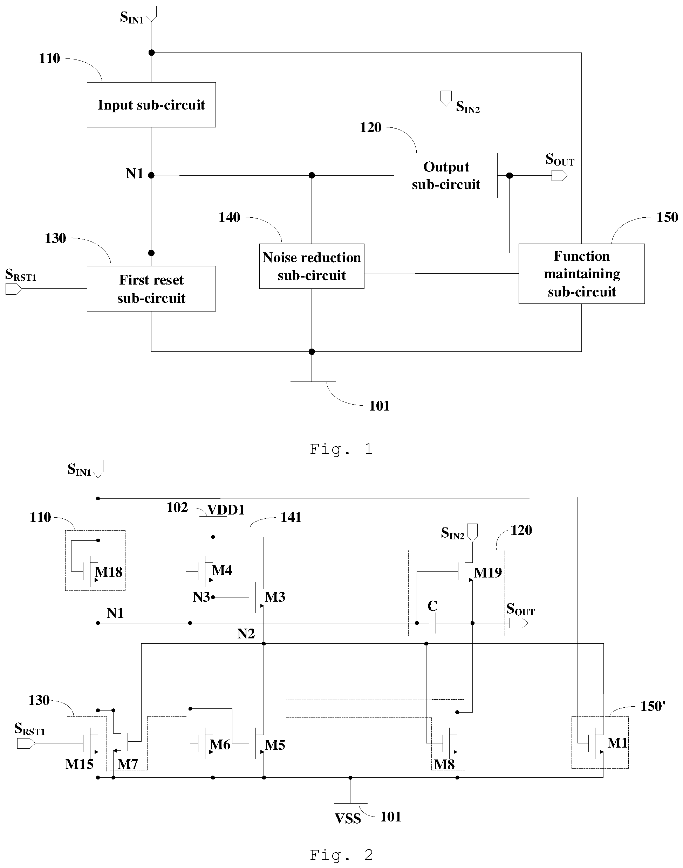

Fig. 1 is a schematic view showing the connection of a gate driving circuit according to an embodiment of the present disclosure.

As shown in Fig. 1, the gate driving circuit comprise an input sub-circuit 110, an output sub-circuit 120, a first reset sub-circuit 130, at least one noise reduction sub-circuit 140 and a function maintaining sub-circuit 150.

The input sub-circuit 110 is electrically connected to a first node N1. The output sub-circuit 120 is electrically connected to the first node N1. The first reset sub-circuit 130 is electrically connected between the first node N1 and a first voltage terminal 101. The at least one noise reduction sub-circuit 140 is electrically connected to the first node N1 and the first voltage terminal 101. The at least one noise reduction sub-circuit 140 is also electrically connected to an output terminal (the output terminal is an output terminal of the gate driving circuit) of the output sub-circuit 120. The function maintaining sub-circuit 150 is electrically connected to the at least one noise reduction sub-circuit 140 and the first voltage terminal 101. An input terminal of the function maintaining sub-circuit 150 is electrically connected to an input terminal of the input sub-circuit 110.

The first voltage terminal 101 is configured to provide a first level. For example, the first voltage terminal 101 is a common ground terminal for providing a common ground terminal voltage signal VSS.

The input sub-circuit 110 is configured to change a potential of the first node N1 from the first level to a second level under the control of a first input signal S_{IN1}. For example, the first level is a low level, and the second level is a high level. The input sub-circuit 110 may pull up the potential of the first node N1 from the low level to the high level. For example, the first node is a pull-up node.

The output sub-circuit 120 is configured to output a gate driving signal S_{OUT} in response to a second input signal S_{IN2}. For example, the output sub-circuit 120 is configured to change the potential of the first node N1 from the second level to a third level under the control of the second input signal S_{IN2} so as to output a gate driving signal. The second level is between the first level and the third level. For example, the third level is a level higher than the second level. That is, the potential of the first node N1 is pulled up from the second level to the third level. In some embodiments, the second input signal S_{IN2} is a clock signal.

The first reset sub-circuit 130 is configured to reset the potential of the first node N1 under the control of a first reset signal S_{RST1}.

The at least one noise reduction sub-circuit 140 is configured to maintain the potential of the first node N1 and a potential of the output terminal of the output sub-circuit 120 at the first level in a case where the potential of the first node N1 is reset.

The function maintaining sub-circuit 150 is configured to control operation of the at least one noise reduction sub-circuit 140 under the control of the first input signal S_{IN1}, so that the at least one noise reduction sub-circuit 140 interrupts (or referred to as decoupling) electrical coupling between the first node N1 and the first voltage terminal 101.

So far, the gate driving circuit according to some embodiments of the present disclosure is provided. In the gate driving circuit, the input sub-circuit changes a potential of the first node from the first level to the second level; the output sub-circuit outputs a gate driving signal; the first reset sub-circuit resets the potential of the first node; the at least one noise reduction sub-circuit maintains the potential of the first node and the potential of the output terminal of the output sub-circuit at the first level in a case where the potential of the first node is reset; and the function maintaining sub-circuit controls the operation of the noise reduction sub-circuit so that the noise reduction sub-circuit interrupts electrical coupling between the first node and the first voltage terminal. By interrupting the electrical coupling between the first node and the first voltage terminal, the potential of the first node is substantially maintained at the second level (for example, a high level), so that the output of the gate driving signal is not affected by a characteristic drift of a switching transistor. Therefore, the gate driving circuit can output a normal gate driving signal.

Fig. 2 is a schematic view showing the connection of a gate driving circuit according to another embodiment of the present disclosure.

In some embodiments, as shown in Fig. 2, the at least one noise reduction sub-circuit comprises a first noise reduction sub-circuit 141.

As shown in Fig. 2, the first noise reduction sub-circuit 141 comprises a third switching transistor M3, a fourth switching transistor M4, a fifth switching transistor M5, a sixth switching transistor M6, a seventh switching transistor M7, and an eighth switching transistor M8.

A first electrode of the third switching transistor M3 is electrically connected to a second voltage terminal 102. For example, the second voltage terminal is configured to provide the second level. For example, the second voltage terminal is a power supply voltage terminal for providing a first power supply voltage VDD1 (as the second level). A second electrode of the third switching transistor M3 is electrically connected to the second node N2. For example, the second node N2 is a pull-down node. A gate of the third switching transistor M3 is electrically connected to a third node N3. For example, as shown in Fig. 2, the third switching transistor is an NMOS (N-channel Metal Oxide Semiconductor) transistor. For another example, the third switching transistor is a PMOS (P-channel Metal Oxide Semiconductor) transistor.

A first electrode and a gate of the fourth switching transistor M4 are electrically connected to the second voltage terminal 102. A second electrode of the fourth switching transistor M4 is electrically connected to the third node N3. For example, as shown in Fig. 2, the fourth switching transistor is an NMOS transistor. For another example, the fourth switching transistor is a PMOS transistor.

A first electrode of the fifth switching transistor M5 is electrically connected to the second node N2. A second electrode of the fifth switching transistor M5 is electrically connected to the first voltage terminal 101. A gate of the fifth switching transistor M5 is electrically connected to the first node N1. For example, as shown in Fig. 2, the fifth switching transistor is an NMOS transistor. For another example, the fifth switching transistor is a PMOS transistor.

A first electrode of the sixth switching transistor M6 is electrically connected to the third node N3. A second electrode of the sixth switching transistor M6 is electrically connected to the first voltage terminal 101. A gate of the sixth switching transistor M6 is electrically connected to the first node N1. For example, as shown in Fig. 2, the sixth switching transistor is an NMOS transistor. For another example, the sixth switching transistor is a PMOS transistor.

A first electrode of the seventh switching transistor M7 is electrically connected to the first node N1. A second electrode of the seventh switching transistor M7 is electrically connected to the first voltage terminal 101. A gate of the seventh switching transistor M7 is electrically connected to the second node N2. For example, as shown in Fig. 2, the seventh switching transistor is an NMOS transistor. For another example, the seventh switching transistor is a PMOS transistor.

A first electrode of the eighth switching transistor M8 is electrically connected to the output terminal of the output sub-circuit 120. A second electrode of the eighth switching transistor M8 is electrically connected to the first voltage terminal 101. A gate of the eighth switching transistor M8 is electrically connected to the second node N2. For example, as shown in Fig. 2, the eighth switching transistor is an NMOS transistor. For another example, the eighth switching transistor is a PMOS transistor.

So far, the circuit structure of the first noise reduction sub-circuit according to some embodiments of the present disclosure is provided.

In some embodiments, the function maintaining sub-circuit 150 adopts the implementation of a function maintaining sub-circuit 150' shown in Fig. 2. The function maintaining sub-circuit 150' comprises a first switching transistor M1. A first electrode of the first switching transistor M1 is electrically connected to the first noise reduction sub-circuit 141. For example, the first electrode of the first switching transistor M1 is electrically connected to the second node N2. A second electrode of the first switching transistor M1 is electrically connected to the first voltage terminal 101. A gate of the first switching transistor M1 is configured to receive the first input signal S_{IN1}. For example, as shown in Fig. 2, the first switching transistor is an NMOS transistor. For another example, the first switching transistor is a PMOS transistor.

The first switching transistor M1 is configured to be turned on after receiving the first input signal S_{IN1}. In this way, a potential of the second node N2 is maintained at the level of the first voltage terminal 101. For example, the first voltage terminal 101 is a common ground terminal, so that the potential of the second node N2 is maintained at the common ground terminal voltage VSS (i.e., a low level). In this way, the seventh switching transistor M7 is turned off. Therefore, the potential of the first node N1 may not be pulled down by the first voltage terminal, so that the gate driving circuit can output the normal gate driving signal.

In some embodiments, as shown in Fig. 2, the input sub-circuit 110 comprises an eighteenth switching transistor M18. A first electrode and a gate of the eighteenth switching transistor M18 are both configured to receive the first input signal S_{IN1}. A second electrode of the eighteenth switching transistor M18 is electrically connected to the first node N1. The eighteenth transistor M18 is configured to be turned on after receiving the first input signal S_{IN1}. In this way, the potential of the first node N1 is changed from the first level (for example, a low level) to the second level (for example, a high level) . For example, as shown in Fig. 2, the eighteenth switching transistor is an NMOS transistor. For another example, the eighteenth switching transistor is a PMOS transistor.

In some embodiments, as shown in Fig. 2, the output sub-circuit 120 comprises a nineteenth switching transistor M19 and a capacitor C.

A first electrode of the nineteenth switching transistor M19 is configured to receive the second input signal S_{IN2}. A second electrode of the nineteenth switching transistor M19 is used as the output terminal of the output sub-circuit 120. A gate of the nineteenth switching transistor M19 is electrically connected to the first node N1. For example, as shown in Fig. 2, the nineteenth switching transistor is an NMOS transistor. For another example, the nineteenth switching transistor is a PMOS transistor.

A first terminal of the capacitor C is electrically connected to the first node N1. A second terminal of the capacitor C is electrically connected to the second electrode of the nineteenth switching transistor M19. For example, the capacitor C is a parasitic capacitor of the nineteenth switching transistor or an external capacitor.

In some embodiments, as shown in Fig. 2, the first reset sub-circuit 130 comprises a fifteenth switching transistor M15. A first electrode of the fifteenth switching transistor M15 is electrically connected to the first node N1. A second electrode of the fifteenth switching transistor M15 is electrically connected to the first voltage terminal 101. A gate of the fifteenth switching transistor M15 is configured to receive the first reset signal S_{RST1}. The fifteenth switching transistor M15 is configured to be turned on after receiving the first reset signal S_{RST1}. In this way, the potential of the first node N1 is changed to the level of the first voltage terminal 101. For example, the potential of the first node N1 is pulled down to a low level, thereby resetting the potential of the first node. For example, as shown in Fig. 2, the fifteenth switching transistor is an NMOS transistor. For another example, the fifteenth switching transistor is a PMOS transistor.

So far, a gate driving circuit according to other embodiments of the present disclosure is provided. In the gate driving circuit, the first switching transistor of the function maintaining sub-circuit is turned on after receiving the first input signal, so that the potential of the second node is maintained at the level of the first voltage terminal, thereby turning off the seventh switching transistor. Therefore, the potential of the first node is not pulled down by the first voltage terminal, so that the output of the gate driving signal is not affected by the characteristic drift of the switching transistor.

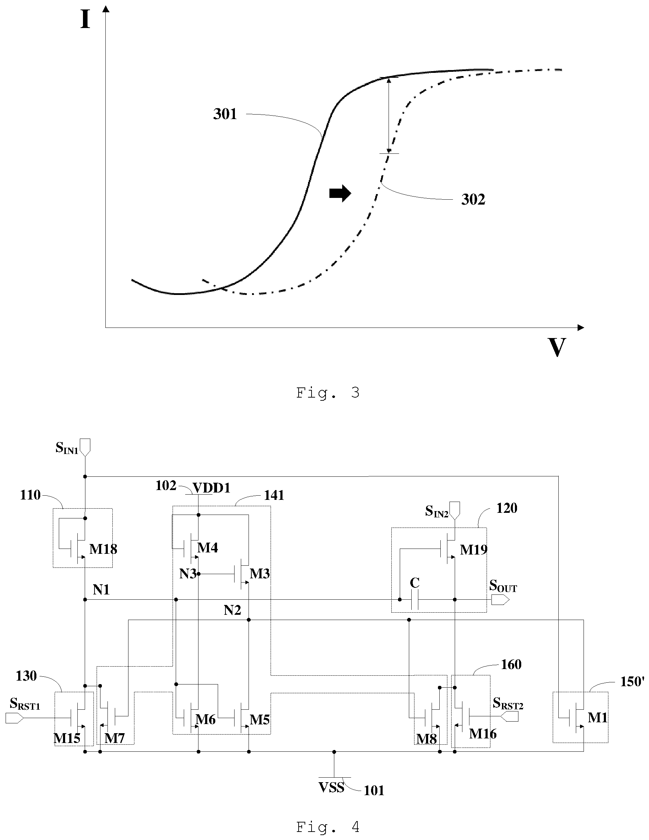

Fig. 3 is a schematic view showing an I-V characteristic curve of a switching transistor according to an embodiment of the present disclosure.

Fig. 3 shows an I-V characteristic curve 301 before the drift and an I-V characteristic curve 302 after the drift of the I-V characteristic curve of the nineteenth switching transistor M19 in Fig. 2. As shown in Fig. 3, the nineteenth switching transistor M19 may drift to the right after a long time of operation, causing the output current of the nineteenth switching transistor to decrease during its operation. Since an output terminal of the nineteenth switching transistor M19 is electrically connected to a gate line in a display area, which results in that the overall load thereof is large, the output capability of the nineteenth switching transistor M19 is also reduced. In addition, the eighteenth switching transistor may also be subjected to a similar characteristic drift after a long time of operation, which may also affect the output of a gate driving signal.

Gate driving circuits are electrically connected in a cascade connection manner. When a certain nineteenth switching transistor provides a first input signal to another gate driving circuit, it may not provide enough current to pull up the potential of the first node N1 of the other gate drive circuit, so that the potential of the second node N2 of the other gate driving circuit cannot be effectively pulled down under the action of a power supply voltage signal. This causes the seventh switching transistor M7 and the eighth switching transistor M8 to be slightly turned on, so that the potential of the first node of the other gate driving circuit and the output signal of the other gate driving circuit cannot be effectively pulled up, thereby further reducing the output gate driving signal.

Since gate driving circuits are electrically connected in a cascade connection manner, the gate driving circuit in each stage (or each row) may affect the output of a gate driving signal of the gate driving circuit in a next stage. Eventually, it is possible to cause the gate driving circuit in a certain row to be substantially unable to output a normal gate driving signal, thereby resulting in failure of the gate driving circuit.

However, in the embodiments of the present disclosure, the function maintaining sub-circuit is provided in the gate driving circuit. The function maintaining sub-circuit controls operation of the noise reduction sub-circuit (for example, the first noise reduction sub-circuit) under the control of the first input signal, so that the noise reduction sub-circuit interrupts electrical coupling between the first node N1 and the first voltage terminal 101. That is, the first switching transistor M1 of the function maintaining sub-circuit is turned on after receiving the first input signal, so that the potential of the second node N2 is maintained at the level of the first voltage terminal, which causes the seventh switching transistor M7 to be turned off. Therefore, the potential of the first node may not be pulled down by the first voltage terminal 101, so that the output terminal may output a normal gate driving signal.

In addition, when the function maintaining sub-circuit controls the operation of the noise reduction sub-circuit (for example, the first noise reduction sub-circuit), the noise reduction sub-circuit may also interrupt electrical coupling between the output terminal of the output sub-circuit and the first voltage terminal 101. That is, the first switching transistor M1 of the function maintaining sub-circuit is turned on after receiving the first input signal, so that the potential of the second node N2 is maintained at the level of the first voltage terminal, which causes the eighth switching transistor M8 to be turned off. Therefore, the potential of the output terminal of the output sub-circuit may not be pulled down by the first voltage terminal 101, thereby outputting a normal gate driving signal.

Fig. 4 is a schematic view showing the connection of a gate driving circuit according to another embodiment of the present disclosure.

As shown in Fig. 4, the gate driving circuit comprises the input sub-circuit 110, the output sub-circuit 120, the first reset sub-circuit 130, the first noise reduction sub-circuit 141, and the function maintaining sub-circuit 150'. These sub-circuits have been described in detail in conjunction with Fig. 2 above.

In some embodiments, as shown in Fig. 4, the gate driving circuit further comprises a second reset sub-circuit 160. The second reset sub-circuit 160 is electrically connected to the first voltage terminal 101 and the output terminal of the output sub-circuit 120. The second reset sub-circuit 160 is configured to reset the potential of the output terminal of the output sub-circuit 120 under the control of a second reset signal S_{RST2}.

In some embodiments, as shown in Fig. 4, the second reset sub-circuit 160 comprises a sixteenth switching transistor M16. A first electrode of the sixteenth switching transistor M16 is electrically connected to the output terminal of the output sub-circuit 120 (for example, the second electrode of the nineteenth switching transistor) . A second electrode of the sixteenth switching transistor M16 is electrically connected to the first voltage terminal 101. A gate of the sixteenth switching transistor M16 is configured to receive the second reset signal S_{RST2}. The sixteenth switching transistor M16 is configured to be turned on after receiving the second reset signal S_{RST2}. In this way, the potential of the output terminal of the output sub-circuit 120 can be reset. For example, as shown in Fig. 2, the sixteenth switching transistor is an NMOS transistor. For another example, the sixteenth switching transistor is a PMOS transistor.

So far, a gate driving circuit according to other embodiments of the present disclosure is provided. A second reset sub-circuit is provided in the gate driving circuit, which may function to reset the potential of the output terminal of the output sub-circuit.

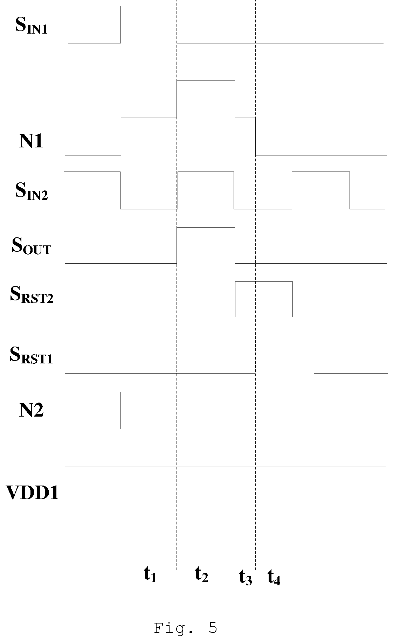

Fig. 5 is a timing diagram showing control signals of a gate driving circuit according to an embodiment of the present disclosure. The working process of the gate driving circuit according to some embodiments of the present disclosure will be described in detail below in conjunction with Figs. 4 and 5. Here, the first voltage VDD1 at a high level and the switching transistors which are all NMOS transistors are taken as an example to describe the working process.

First, in a first stage t₁, the first input signal S_{IN1} is at a high level, so that the eighteenth switching transistor M18 is turned on. In this way, the first node N1 is pulled up to a high level (as the second level) . Since the first node N1 is pulled up to the high level, the fifth switching transistor M5 and the sixth switching transistor M6 are turned on. This causes the potential of the second node N2 to be reduced to a low level (i.e., the level VSS of the first voltage terminal 101), and the operation of the first noise reduction sub-circuit 141 stops.

Furthermore, since the first input signal S_{IN1} is at a high level, the first switching transistor M1 is turned on, which further ensures that the second node N2 is pulled down to the low level. This enables the seventh switching transistor M7 and the eighth switching transistor to be fully turned off, thereby ensuring that the first node N1 is at a high level, and preventing the potential of the output terminal of the output sub-circuit from being pulled down by the first voltage terminal. This may make it possible that a gate driving signal is not affected by the characteristic drift of the nineteenth switching transistor or the eighteenth switching transistor when the gate driving signal is output in a subsequent stage.

In addition, since the first node N1 is pulled up to the high level, the nineteenth switching transistor M19 is turned on. However, since the second input signal S_{IN2} is at a low level, the output sub-circuit 120 outputs a low-level gate driving signal S_{OUT}. In this embodiment, the low-level gate driving signal S_{OUT} is an inactive gate driving signal.

Next, in a second stage t₂, the first input signal S_{IN1} changes from the high level to a low level, and the second input signal S_{IN2} changes from the low level to a high level. Due to the bootstrap action of the capacitor C1, the potential of the first node N1 is continuously pulled up to a higher level (as the third level) . Since the nineteenth switching transistor M19 is turned on, the output terminal of the output sub-circuit 120 outputs a high-level gate driving signal S_{OUT}. The high-level gate driving signal S_{OUT} is an effective gate driving signal.

Next, in a third stage t₃, the second reset signal S_{RST2} changes from a low level to a high level, so that the sixteenth switching transistor M16 is turned on. In this way, the potential of the first node N1 is dropped to the second level, but not to the first level (i.e., the low level). Since the sixteenth switching transistor M16 is turned on, the potential of the output terminal of the output sub-circuit 120 drops. In addition, in the third stage t₃, the second input signal S_{IN2} changes from the high level to the low level. The potential of the first node N1 drops, the potential of the output terminal of the output sub-circuit 120 drops, and the second input signal S_{IN2} becomes the low level, so the high-level gate driving signal S_{OUT} becomes a low-level signal.

Next, in a fourth stage t₄, the first reset signal S_{RST1} changes from the low level to the high level, so that the fifteenth switching transistor M15 is turned on. This causes the potential of the first node N1 to be pulled down to a low level. The fourth switching transistor M4 is turned on under the action of the high level of the first power supply voltage VDD1. Therefore, the potential of the third node N3 becomes a high level, so that the third switching transistor M3 is turned on, which raises the potential of the second node N2 to a high level. The seventh switching transistor M7 and the eighth switching transistor M8 are turned on under the action of the potential of the second node N2, so that the potential of the first node N1 is reduced to the low level and the output gate driving signal S_{OUT} is at a low level, so that large noise and erroneous output signals will not be caused.

So far, the working process of the gate driving circuit according to some embodiments of the present disclosure is provided. During the working process, since the first switching transistor M1 is turned on under the control of the first input signal S_{IN1}, it is ensured that the potential of the second node N2 is pulled down to a low level. This enables the seventh switching transistor M7 and the eighth switching transistor M8 to be fully turned off, thereby ensuring that the first node N1 is at a high level, and preventing the potential of the output terminal of the output sub-circuit from being pulled down by the first voltage terminal. This is beneficial to output a normal gate driving signal in a subsequent stage.

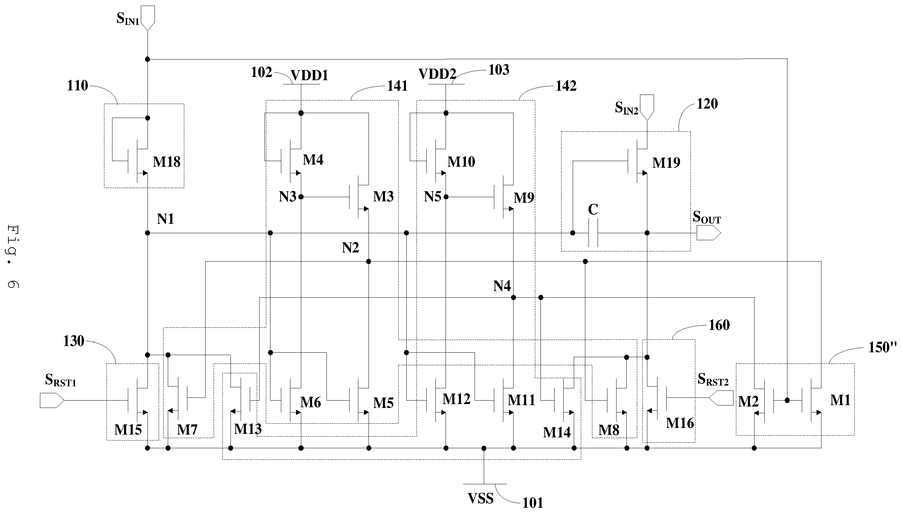

Fig. 6 is a schematic view showing the connection of a gate driving circuit according to another embodiment of the present disclosure.

As shown in Fig. 6, the gate driving circuit comprises the input sub-circuit 110, the output sub-circuit 120, the first reset sub-circuit 130, the first noise reduction sub-circuit 141 and the second reset sub-circuit 160.

In some embodiments, as shown in Fig. 2, the at least one noise reduction sub-circuit comprises a second noise reduction sub-circuit 142 in addition to the first noise reduction sub-circuit 141.

As shown in Fig. 2, the second noise reduction sub-circuit 142 comprises a ninth switching transistor M9, a tenth switching transistor M10, an eleventh switching transistor M11, a twelfth switching transistor M12, a thirteenth switching transistor M13, and a fourteenth switching transistor M14.

A first electrode of the ninth switching transistor M9 is electrically connected to a third voltage terminal 103. For example, the third voltage terminal 103 is configured to provide a second level. For example, the third voltage terminal is a power supply voltage terminal for providing a second power supply voltage VDD2 (as the second level) . A second electrode of the ninth switching transistor M9 is electrically connected to a fourth node N4. For example, the fourth node N4 is a pull-down node. A gate of the ninth switching transistor M9 is electrically connected to a fifth node N5. For example, as shown in Fig. 6, the ninth switching transistor is an NMOS transistor. For another example, the ninth switching transistor is a PMOS transistor.

A first electrode and a gate of the tenth switching transistor M10 are electrically connected to the third voltage terminal 103. A second electrode of the tenth switching transistor M10 is electrically connected to the fifth node N5. For example, as shown in Fig. 6, the tenth switching transistor is an NMOS transistor. For another example, the tenth switching transistor is a PMOS transistor.

A first electrode of the eleventh switching transistor M11 is electrically connected to the fourth node N4. A second electrode of the eleventh switching transistor M11 is electrically connected to the first voltage terminal 101. A gate of the eleventh switching transistor M11 is electrically connected to the first node N1. For example, as shown in Fig. 6, the eleventh switching transistor is an NMOS transistor. For another example, the eleventh switching transistor is a PMOS transistor.

A first electrode of the twelfth switching transistor M12 is electrically connected to the fifth node N5. A second electrode of the twelfth switching transistor M12 is electrically connected to the first voltage terminal 101. A gate of the twelfth switching transistor M12 is electrically connected to the first node N1. For example, as shown in Fig. 6, the twelfth switching transistor is an NMOS transistor. For another example, the twelfth switching transistor is a PMOS transistor.

A first electrode of the thirteenth switching transistor M13 is electrically connected to the first node N1. A second electrode of the thirteenth switching transistor M13 is electrically connected to the first voltage terminal 101. A gate of the thirteenth switching transistor M13 is electrically connected to the fourth node N4. For example, as shown in Fig. 6, the thirteenth switching transistor is an NMOS transistor. For another example, the thirteenth switching transistor is a PMOS transistor.

A first electrode of the fourteenth switching transistor M14 is electrically connected to the output terminal of the output sub-circuit 120 (for example, the second electrode of the nineteenth switching transistor M19) . A second electrode of the fourteenth switching transistor M14 is electrically connected to the first voltage terminal 101. A gate of the fourteenth switching transistor M14 is electrically connected to the fourth node N4. For example, as shown in Fig. 6, the fourteenth switching transistor is an NMOS transistor. For another example, the fourteenth switching transistor is a PMOS transistor.

So far, a circuit structure of the second noise reduction sub-circuit according to some embodiments of the present disclosure is provided. Here, the first noise reduction sub-circuit 141 and the second noise reduction sub-circuit 142 can work alternately. That is, when one of the two noise reduction sub-circuits works, the other does not work. For example, when the first power supply voltage VDD1 is at a high level and the second power supply voltage VDD2 is at a low level, the first noise reduction sub-circuit works but the second noise reduction sub-circuit does not work, and vice versa. This may increase the service life of the noise reduction sub-circuits.

In some embodiments, the function maintaining sub-circuit 150 may adopt the implementation of a function maintaining sub-circuit 150" as shown in Fig. 6. The function maintaining sub-circuit 150" comprises a second switching transistor M2 in addition to the first switching transistor M1.

As shown in Fig. 6, a first electrode of the second switching transistor M2 is electrically connected to the second noise reduction sub-circuit 142. For example, the first electrode of the second switching transistor M2 is electrically connected to the fourth node N4. A second electrode of the second switching transistor M2 is electrically connected to the first voltage terminal 101. A gate of the second switching transistor M2 is configured to receive the first input signal S_{IN1}. For example, as shown in Fig. 2, the second switching transistor is an NMOS transistor. For another example, the second switching transistor is a PMOS transistor.

The second switching transistor M2 is configured to be turned on after receiving the first input signal S_{IN1}. In this way, a potential of the fourth node N4 is maintained at the level of the first voltage terminal 101. For example, the first voltage terminal 101 is a common ground terminal, so that the potential of the fourth node N4 is maintained at the common ground terminal voltage VSS. In this way, the thirteenth switching transistor M13 and the fourteenth switching transistor M14 are turned off. Therefore, the potential of the first node N1 and the potential of the output terminal of the output sub-circuit may not be pulled down by the first voltage terminal, so that the output of a gate driving signal may not be affected by the characteristic drift of the switching transistors (such as the nineteenth switching transistor and/or the eighteenth switching transistor) . The gate driving circuit may output a normal gate driving signal.

So far, a gate driving circuit according to other embodiments of the present disclosure is provided. The gate circuit comprises two noise reduction sub-circuits (i.e., the first noise reduction sub-circuit and the second noise reduction sub-circuit). Correspondingly, the function maintaining sub-circuit of the gate driving circuit comprises two switching transistors (i.e., the first switching transistor and the second switching transistor) to control operation of the two noise reduction sub-circuits respectively, so that the two noise reduction sub-circuits respectively interrupt electrical coupling between the first node and the first voltage terminal, which allows that the output of a gate driving signal is not affected by the characteristic drift of the switching transistor.

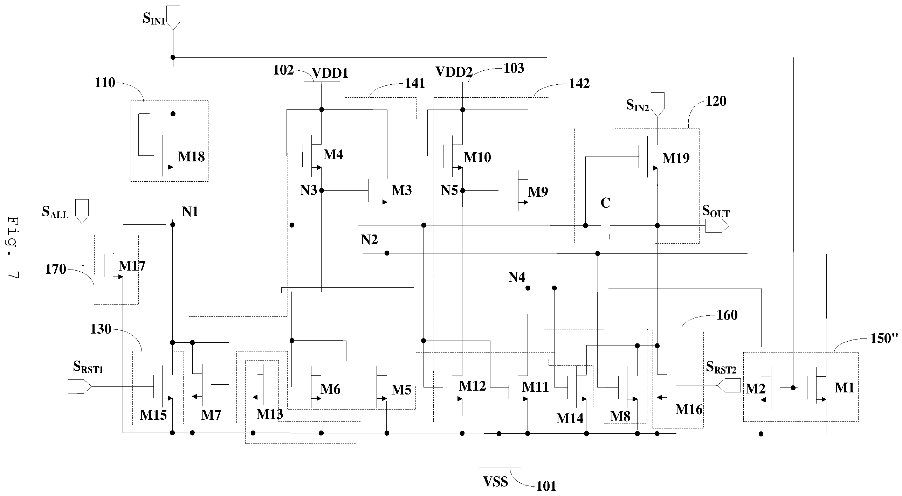

Fig. 7 is a schematic view showing the connection of a gate driving circuit according to another embodiment of the present disclosure.

Based on the gate driving circuit shown in Fig. 6, the gate driving circuit shown in Fig. 7 further comprises a third reset sub-circuit 170. The third reset sub-circuit 170 is electrically connected to the first node N1 and the first voltage terminal 101. The third reset sub-circuit 170 is configured to reset the potential of the first node under control of a global reset signal S_{ALL}.

In some embodiments, the third reset sub-circuit 170 comprises a seventeenth switching transistor M17. A first electrode of the seventeenth switching transistor M17 is electrically connected to the first node N1. A second electrode of the seventeenth switching transistor M17 is electrically connected to the first voltage terminal 101. A gate of the seventeenth switching transistor M17 is configured to receive the global reset signal S_{ALL}. The seventeenth switching transistor M17 is configured to be turned on after receiving the global reset signal S_{ALL}. In this way, the potential of the first node N1 is changed to the level of the first voltage terminal 101. For example, the potential of the first node N1 is reset to a low level.

For example, when it is necessary to reset the first nodes of all the gate driving circuits in a full screen at the same time, the global reset signal S_{ALL} may be input to the third reset sub-circuits of all the gate driving circuits. In this way, the seventeenth switching transistors of the third reset sub-circuits of all the gate driving circuits are turned on, so that the first nodes of all the gate driving circuits are reset.

It should be noted that, the third reset sub-circuit which is not limited to being provided in the gate driving circuit shown in Fig. 7, may also be provided in other gate driving circuits. For example, the third reset sub-circuit may also be provided in the gate driving circuit shown in Fig. 1, 2 or 4. Therefore, the scope of the embodiments of the present disclosure is not limited to this.

In the embodiments of the present disclosure, a gate driving circuit is provided. In some embodiments, as shown in Fig. 7, the gate driving circuit comprises a first switching transistor M1 to a nineteenth switching transistor M19 and a capacitor C.

A first electrode of the first switching transistor M1 is electrically connected to a second node N2. A second electrode of the first switching transistor M1 is electrically connected to a first voltage terminal 101 for providing a first level. A gate of the first switching transistor M1 is configured to receive a first input signal S_{IN1}.

A first electrode of the second switching transistor M2 is electrically connected to a fourth node N4. A second electrode of the second switching transistor M2 is electrically connected to the first voltage terminal 101. A gate of the second switching transistor M2 is configured to receive the first input signal S_{IN1}.

A first electrode of the third switching transistor M3 is electrically connected to a second voltage terminal 102. A second electrode of the third switching transistor M3 is electrically connected to the second node N2. A gate of the third switching transistor M3 is electrically connected to a third node N3.

A first electrode and a gate of the fourth switching transistor M4 are electrically connected to the second voltage terminal 102. A second electrode of the fourth switching transistor M4 is electrically connected to the third node N3.

A first electrode of the fifth switching transistor M5 is electrically connected to the second node N2. A second electrode of the fifth switching transistor M5 is electrically connected to the first voltage terminal 101. A gate of the fifth switching transistor M5 is electrically connected to a first node N1.

A first electrode of the sixth switching transistor M6 is electrically connected to the third node N3. A second electrode of the sixth switching transistor M6 is electrically connected to the first voltage terminal 101. A gate of the sixth switching transistor M6 is electrically connected to the first node N1.

A first electrode of the seventh switching transistor M7 is electrically connected to the first node N1. A second electrode of the seventh switching transistor M7 is electrically connected to the first voltage terminal 101. A gate of the seventh switching transistor M7 is electrically connected to the second node N2.

A first electrode of the eighth switching transistor M8 is electrically connected to an output terminal (that is, an output terminal of the gate driving circuit) . A second electrode of the eighth switching transistor M8 is electrically connected to the first voltage terminal 101. A gate of the eighth switching transistor M8 is electrically connected to the second node N2.

A first electrode of the ninth switching transistor M9 is electrically connected to a third voltage terminal 103. A second electrode of the ninth switching transistor M9 is electrically connected to the fourth node N4. A gate of the ninth switching transistor M9 is electrically connected to a fifth node N5.

A first electrode and a gate of the tenth switching transistor M10 are electrically connected to the third voltage terminal 103. A second electrode of the tenth switching transistor M10 is electrically connected to the fifth node N5.

A first electrode of the eleventh switching transistor M11 is electrically connected to the fourth node N4. A second electrode of the eleventh switching transistor M11 is electrically connected to the first voltage terminal 101. A gate of the eleventh switching transistor M11 is electrically connected to the first node N1.

A first electrode of the twelfth switching transistor M12 is electrically connected to the fifth node N5. A second electrode of the twelfth switching transistor M12 is electrically connected to the first voltage terminal 101. A gate of the twelfth switching transistor M12 is electrically connected to the first node N1.

A first electrode of the thirteenth switching transistor M13 is electrically connected to the first node N1. A second electrode of the thirteenth switching transistor M13 is electrically connected to the first voltage terminal 101. A gate of the thirteenth switching transistor M13 is electrically connected to the fourth node N4.

A first electrode of the fourteenth switching transistor M14 is electrically connected to the output terminal. A second electrode of the fourteenth switching transistor M14 is electrically connected to the first voltage terminal 101. A gate of the fourteenth switching transistor M14 is electrically connected to the fourth node N4.

A first electrode of the fifteenth switching transistor M15 is electrically connected to the first node N1. A second electrode of the fifteenth switching transistor M15 is electrically connected to the first voltage terminal 101. A gate of the fifteenth switching transistor M15 is configured to receive a first reset signal S_{RST1}.

A first electrode of the sixteenth switching transistor M16 is electrically connected to the output terminal. A second electrode of the sixteenth switching transistor M16 is electrically connected to the first voltage terminal 101. A gate of the sixteenth switching transistor M16 is configured to receive a second reset signal S_{RST2}.

A first electrode of the seventeenth switching transistor M17 is electrically connected to the first node N1. A second electrode of the seventeenth switching transistor M17 is electrically connected to the first voltage terminal 101. Agate of the seventeenth switching transistor M17 is configured to receive a global reset signal S_{ALL}.

A first electrode and a gate of the eighteenth switching transistor M18 are configured to receive the first input signal S_{IN1}. A second electrode of the eighteenth switching transistor M18 is electrically connected to the first node N1.

A first electrode of the nineteenth switching transistor M19 is configured to receive a second input signal S_{IN2}. A second electrode of the nineteenth switching transistor M19 is used as the output terminal. A gate of the nineteenth switching transistor M19 is electrically connected to the first node N1.

A first terminal of the capacitor C is electrically connected to the first node N1. A second terminal of the capacitor C is electrically connected to the second electrode of the nineteenth switching transistor M19.

So far, the gate driving circuit according to some embodiments of the present disclosure is provided.

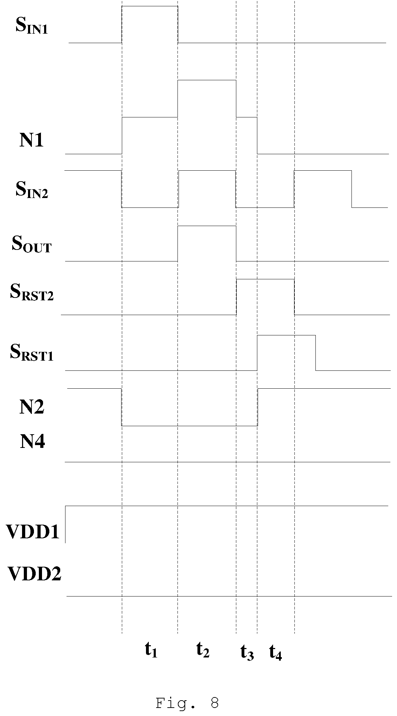

Fig. 8 is a timing diagram showing control signals of a gate driving circuit according to another embodiment of the present disclosure. Here, the working process of the gate driving circuit when the first power supply voltage VDD1 is at a high level and the second power supply voltage VDD2 is at a low level is the same as or similar to the working process of the gate driving circuit described above in conjunction with Fig. 5 and Fig. 4, and will not be described in detail here. In addition, the working process of the gate driving circuit when the first power supply voltage VDD1 is at a low level and the second power supply voltage VDD2 is at a high level is also similar to the working process of the gate driving circuit described above in conjunction with Fig. 5 and Fig. 4, and will not be described in detail here.

In some embodiments of the present disclosure, a display device is also provided. The display device comprises a plurality of gate driving circuits as described above.

In some embodiments, the plurality of gate driving circuits comprise N gate driving circuits, where N is a positive integer.

In the N gate driving circuits, the gate driving signal output by an (i-k)-th gate driving circuit is used as the first input signal of an i-th gate driving circuit, the gate driving signal output by an (i+k+1)-th gate driving circuit is used as the first reset signal of the i-th gate driving circuit, and the gate driving signal output by an (i+k)-th gate driving circuit is used as the second reset signal of the i-th gate driving circuit, where k+1≤i≤N-k-1 and i is a positive integer, 1≤k≤N-2 and k is a positive integer.

In some embodiments, k represents the number of lines of time occupied by a high-level signal in one clock cycle. For example, one clock cycle is 6 lines of time, and the time occupied by the high-level signal is 3 lines of time, where k is 3. Here, one line of time refers to the time taken for scanning one row of the display panel. For example, one line of time may be 7.4 microseconds. In this way, it is beneficial to realize the fit of the signal timing between the gate driving circuits.

In the N gate driving circuits, the first input signals of the first to k-th gate driving circuits are the first input signals provided by an external circuit, the first reset signals of the (N-k)-th to N-th gate driving circuits are the first reset signals provided by the external circuit, and the second reset signals of the (N-k+1)-th to N-th gate driving circuits are the second reset signals provided by the external circuit.

Those skilled in the art can understand that the foregoing embodiment only describes one cascade connection manner of the plurality of gate driving circuits, but the plurality of gate driving circuits in the embodiments of the present disclosure may also adopt other cascading manners. Therefore, the scope of the embodiments of the present disclosure is not limited to this.

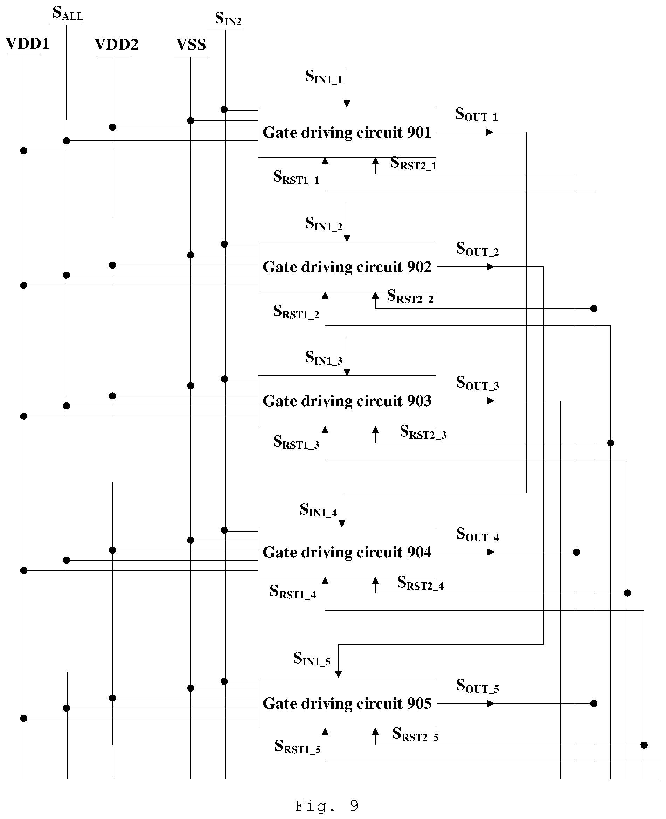

Fig. 9 is a schematic view showing the cascade connection of gate driving circuits of a display device according to an embodiment of the present disclosure. Fig. 9 shows the cascade connection of the gate driving circuits when k=3.

As shown in Fig. 9, each gate driving circuit receives a first power supply voltage VDD1, a second power supply voltage VDD2, a common ground terminal voltage VSS, a second input signal S_{IN2} and a global reset signal S_{ALL}.

First input signals S_{IN1_1} to S_{IN1_3} of gate driving circuits 901 to 903 are the first input signals provided by an external circuit (not shown in Fig. 9) . A gate driving signal S_{OUT_1} output by the first gate driving circuit 901 is used as a first input signal S_{IN1_4} of an fourth gate driving circuit 904, and a gate driving signal S_{OUT_2} output by the second gate driving circuit 902 is used as a first input signal S_{IN1_5} of a fifth gate driving circuit 905, and so forth.

As shown in Fig. 9, a gate driving signal S_{OUT_5} output by the fifth gate driving circuit 905 is used as a first reset signal S_{RST1_1} of the first gate driving circuit 901, a gate driving signal output by a sixth gate driving circuit (not shown in Fig. 9) is used as a first reset signal S_{RST1_2} of the second gate driving circuit 902, a gate driving signal output by a seventh gate driving circuit (not shown in Fig. 9) is used as a first reset signal S_{RST1_3} of the third gate driving circuit 903, a gate driving signal output by an eighth gate driving circuit (not shown in Fig. 9) is used as a first reset signal S_{RST1_4} of the fourth gate driving circuit 904, a gate driving signal output by a ninth gate driving circuit (not shown in Fig. 9) is used as a first reset signal S_{RST1_5} of the fifth gate driving circuit 905, and so forth. The first reset signals of the (N-3)-th to N-th gate driving circuits are the first reset signals provided by the external circuit (not shown in Fig. 9).

As shown in Fig. 9, a gate driving signal S_{OUT_4} output by the fourth gate driving circuit 904 is used as a second reset signal S_{RST2_1} of the first gate driving circuit 901, the gate driving signal S_{OUT_5} output by the fifth gate driving circuit 905 is used as a second reset signal S_{RST2_2} of the second gate driving circuit 902, the gate driving signal output by the sixth gate driving circuit (not shown in Fig. 9) is used as a second reset signal S_{RST2_3} of the third gate driving circuit 903, the gate driving signal output by the seventh gate driving circuit (not shown in Fig. 9) is used as a second reset signal S_{RST2_4} of the fourth gate driving circuit 904, and the gate driving signal output by the eighth gate driving circuit is used as a second reset signal S_{RST2_5} of the fifth gate driving circuit 905, and so forth. The second reset signals of the (N-2) -th to N-th gate driving circuits are the second reset signals provided by the external circuit.

Regarding the working process of each gate driving circuit, reference may be made to the working process of the gate driving circuit described above in conjunction with Fig. 5 and Fig. 4, which may not be repeated here.

In some embodiments, the gate driving signal output by the first gate driving circuit is used to scan the first row of sub-pixels on the display panel, the gate driving signal output by the second gate driving circuit is used to scan the second row of sub-pixels on the display panel, and so forth. The gate driving signal output by the N-th gate driving circuit is used to scan the N-th row of sub-pixels on the display panel.

In other embodiments, the gate driving signal output by the first gate driving circuit is used to scan the N-th row of sub-pixels on the display panel, the gate driving signal output by the second gate driving circuit is used to scan the (N-1)-th row of sub-pixels on the display panel, and so forth. The gate driving signal output by the N-th gate driving circuit is used to scan the first row of sub-pixels on the display panel.

It should be noted that the sub-pixels in the first row to the N-th row are arranged in order from near to far according to a distance from the binding area.

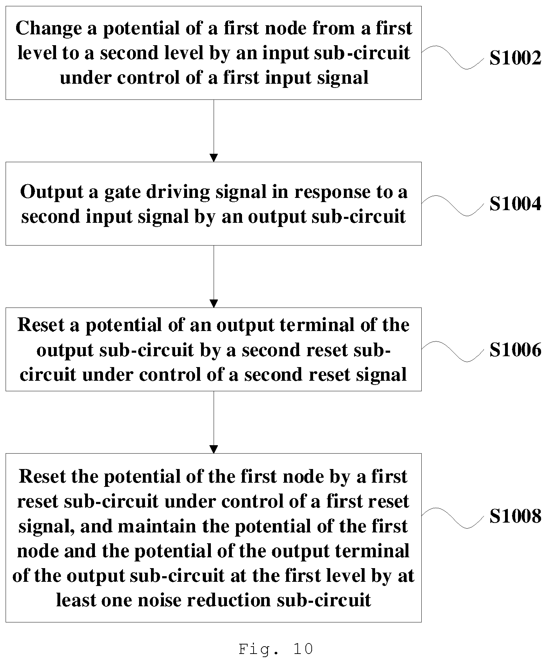

Fig. 10 is a flowchart showing a control method for a gate driving circuit according to an embodiment of the present disclosure. As shown in Fig. 10, the control method comprises steps S1002 to S1008.

At step S1002, a potential of a first node is changed from a first level to a second level by an input sub-circuit under control of a first input signal.

At step S1004, a gate driving signal is output in response to a second input signal by an output sub-circuit.

At step S1006, a potential of an output terminal of the output sub-circuit is reset by a second reset sub-circuit under control of a second reset signal.

At step S1008, the potential of the first node is reset by a first reset sub-circuit under control of a first reset signal, and the potential of the first node and the potential of the output terminal of the output sub-circuit is maintained at the first level by at least one noise reduction sub-circuit.

In the changing of the potential of the first node from the first level to the second level by the input sub-circuit, a function maintaining sub-circuit controls operation of the at least one noise reduction sub-circuit under control of the first input signal, so that the at least one noise reduction sub-circuit interrupts electrical coupling between the first node and a first voltage terminal.

In the control method of the above-described embodiments, the function maintaining sub-circuit is controlled by the first input signal to control operation of at least one noise reduction sub-circuit, so that the at least one noise reduction sub-circuit interrupts the electrical coupling between the first node and the first voltage terminal, so that the potential of the first node is substantially maintained at the second level (for example, a high level), which allows that the output of a gate driving signal is not affected by the characteristic drift of the switching transistor.

Hereto, various embodiments of the present disclosure have been described in detail. Some details well known in the art are not described to avoid obscuring the concept of the present disclosure. According to the above description, those skilled in the art would fully know how to implement the technical solutions disclosed herein.

Although some specific embodiments of the present disclosure have been described in detail by way of examples, those skilled in the art should understand that the above examples are only for the purpose of illustration and are not intended to limit the scope of the present disclosure. It should be understood by those skilled in the art that modifications to the above embodiments or equivalently substitution of part of the technical features may be made without departing from the scope and spirit of the present disclosure. The scope of the present disclosure is defined by the appended claims.

## Claims

1. A gate driving circuit, **characterized by** comprising:
an input sub-circuit electrically connected to a first node and configured to change a potential of the first node from a first level to a second level under control of a first input signal;
an output sub-circuit electrically connected to the first node and configured to output a gate driving signal in response to a second input signal;
a first reset sub-circuit configured to reset the potential of the first node under control of a first reset signal;
at least one noise reduction sub-circuit electrically connected to the first node and a first voltage terminal for providing the first level, and configured to maintain the potential of the first node and a potential of an output terminal of the output sub-circuit at the first level in a case where the potential of the first node is reset; and
a function maintaining sub-circuit electrically connected to the at least one noise reduction sub-circuit and the first voltage terminal, and configured to control operation of the at least one noise reduction sub-circuit under control of the first input signal, so that the at least one noise reduction sub-circuit interrupts electrical coupling between the first node and the first voltage terminal.

2. The gate driving circuit according to claim 1, **characterized in that**
the at least one noise reduction sub-circuit comprises a first noise reduction sub-circuit; and
the function maintaining sub-circuit comprises a first switching transistor, wherein a first electrode of the first switching transistor is electrically connected to the first noise reduction sub-circuit, a second electrode of the first switching transistor is electrically connected to the first voltage terminal, and a gate of the first switching transistor is configured to receive the first input signal.

3. The gate driving circuit according to claim 2, **characterized in that**
the at least one noise reduction sub-circuit further comprises a second noise reduction sub-circuit; and
the function maintaining sub-circuit further comprises a second switching transistor, wherein a first electrode of the second switching transistor is electrically connected to the second noise reduction sub-circuit, a second electrode of the second switching transistor is electrically connected to the first voltage terminal, and a gate of the second switching transistor is configured to receive the first input signal.

4. The gate driving circuit according to claim 2, **characterized in that** the first noise reduction sub-circuit comprises:
a third switching transistor, wherein a first electrode of the third switching transistor is electrically connected to a second voltage terminal, a second electrode of the third switching transistor is electrically connected to a second node, and a gate of the third switching transistor is electrically connected to a third node;
a fourth switching transistor, wherein a first electrode and a gate of the fourth switching transistor are electrically connected to the second voltage terminal, and a second electrode of the fourth switching transistor is electrically connected to the third node;
a fifth switching transistor, wherein a first electrode of the fifth switching transistor is electrically connected to the second node, a second electrode of the fifth switching transistor is electrically connected to the first voltage terminal, and a gate of the fifth switching transistor is electrically connected to the first node;
a sixth switching transistor, wherein a first electrode of the sixth switching transistor is electrically connected to the third node, a second electrode of the sixth switching transistor is electrically connected to the first voltage terminal, and a gate of the sixth switching transistor is electrically connected to the first node;
a seventh switching transistor, wherein a first electrode of the seventh switching transistor is electrically connected to the first node, a second electrode of the seventh switching transistor is electrically connected to the first voltage terminal, and a gate of the seventh switching transistor is electrically connected to the second node; and
an eighth switching transistor, wherein a first electrode of the eighth switching transistor is electrically connected to the output terminal of the output sub-circuit, a second electrode of the eighth switching transistor is electrically connected to the first voltage terminal, and a gate of the eight switching transistor is electrically connected to the second node;
wherein the first electrode of the first switching transistor is electrically connected to the second node.

5. The gate driving circuit according to claim 4, **characterized in that** the second voltage terminal is configured to provide the second level.

6. The gate driving circuit according to claim 3, **characterized in that** the second noise reduction sub-circuit comprises:
a ninth switching transistor, wherein a first electrode of the ninth switching transistor is electrically connected to a third voltage terminal, a second electrode of the ninth switching transistor is electrically connected to a fourth node, and a gate of the ninth switching transistor is electrically connected to a fifth node;
a tenth switching transistor, wherein a first electrode and a gate of the tenth switching transistor are electrically connected to the third voltage terminal, and a second electrode of the tenth switching transistor is electrically connected to the fifth node;
an eleventh switching transistor, wherein a first electrode of the eleventh switching transistor is electrically connected to the fourth node, a second electrode of the eleventh switching transistor is electrically connected to the first voltage terminal, and a gate of the eleventh switching transistor is electrically connected to the first node;
a twelfth switching transistor, wherein a first electrode of the twelfth switching transistor is electrically connected to the fifth node, a second electrode of the twelfth switching transistor is electrically connected to the first voltage terminal, and a gate of the twelfth switching transistor is electrically connected to the first node;
a thirteenth switching transistor, wherein a first electrode of the thirteenth switching transistor is electrically connected to the first node, a second electrode of the thirteenth switching transistor is electrically connected to the first voltage terminal, and a gate of the thirteen switching transistor is electrically connected to the fourth node; and
a fourteenth switching transistor, wherein a first electrode of the fourteenth switching transistor is electrically connected to the output terminal of the output sub-circuit, a second electrode of the fourteenth switching transistor is electrically connected to the first voltage terminal, and a gate of the fourteenth switching transistor is electrically connected to the fourth node;
wherein the first electrode of the second switching transistor is electrically connected to the fourth node.

7. The gate driving circuit according to claim 6, **characterized in that** the third voltage terminal is configured to provide the second level.

8. The gate driving circuit according to any one of claims 1 to 7, **characterized in that** the first reset sub-circuit comprises a fifteenth switching transistor, wherein a first electrode of the fifteenth switching transistor is electrically connected to the first node, a second electrode of the fifteenth switching transistor is electrically connected to the first voltage terminal, and a gate of the fifteenth switching transistor is configured to receive the first reset signal.

9. The gate driving circuit according to any one of claims 1 to 8, **characterized by** further comprising:
a second reset sub-circuit configured to reset the potential of the output terminal of the output sub-circuit under control of a second reset signal.

10. The gate driving circuit according to claim 9, **characterized in that** the second reset sub-circuit comprises a sixteenth switching transistor, wherein a first electrode of the sixteenth switching transistor is electrically connected to the output terminal of the output sub-circuit, a second electrode of the sixteenth switching transistor is electrically connected to the first voltage terminal, and a gate of the sixteenth switching transistor is configured to receive the second reset signal.

11. The gate driving circuit according to any one of claims 1 to 10, **characterized by** further comprising:
a third reset sub-circuit configured to reset the potential of the first node under control of a global reset signal.

12. The gate driving circuit according to claim 11, **characterized in that** the third reset sub-circuit comprises a seventeenth switching transistor, wherein a first electrode of the seventeenth switching transistor is electrically connected to the first node, a second electrode of the seventeenth switching transistor is electrically connected to the first voltage terminal, and a gate of the seventeen switching transistor is configured to receive the global reset signal.

13. The gate driving circuit according to any one of claims 1 to 12, **characterized in that** the input sub-circuit comprises an eighteenth switching transistor, wherein a first electrode and a gate of the eighteenth switching transistor are configured to receive the first input signal, and a second electrode of the eighteenth switching transistor is electrically connected to the first node.

14. The gate driving circuit according to any one of claims 1 to 13, **characterized in that** the output sub-circuit comprises:
a nineteenth switching transistor, wherein a first electrode of the nineteenth switching transistor is configured to receive the second input signal, a second electrode of the nineteenth switching transistor is used as the output terminal of the output sub-circuit, and a gate of the nineteenth switching transistor is electrically connected to the first node; and
a capacitor, wherein a first terminal of the capacitor is electrically connected to the first node, and a second terminal of the capacitor is electrically connected to the second electrode of the nineteenth switching transistor.

15. A gate driving circuit, **characterized by** comprising:
a first switching transistor, wherein a first electrode of the first switching transistor is electrically connected to a second node, a second electrode of the first switching transistor is electrically connected to a first voltage terminal for providing a first level, and a gate of the first switching transistor is configured to receive a first input signal;
a second switching transistor, wherein a first electrode of the second switching transistor is electrically connected to a fourth node, a second electrode of the second switching transistor is electrically connected to the first voltage terminal, and a gate of the second switching transistor is configured to receive the first input signal;
a third switching transistor, wherein a first electrode of the third switching transistor is electrically connected to a second voltage terminal, a second electrode of the third switching transistor is electrically connected to the second node, and a gate of the third switching transistor is electrically connected to a third node;
a fourth switching transistor, wherein a first electrode and a gate of the fourth switching transistor are electrically connected to the second voltage terminal, and a second electrode of the fourth switching transistor is electrically connected to the third node;
a fifth switching transistor, wherein a first electrode of the fifth switching transistor is electrically connected to the second node, a second electrode of the fifth switching transistor is electrically connected to the first voltage terminal, and a gate of the fifth switching transistor is electrically connected to a first node;
a sixth switching transistor, wherein a first electrode of the sixth switching transistor is electrically connected to the third node, a second electrode of the sixth switching transistor is electrically connected to the first voltage terminal, and a gate of the sixth switching transistor is electrically connected to the first node;
a seventh switching transistor, wherein a first electrode of the seventh switching transistor is electrically connected to the first node, a second electrode of the seventh switching transistor is electrically connected to the first voltage terminal, and a gate of the seventh switching transistor is electrically connected to the second node;
an eighth switching transistor, wherein a first electrode of the eighth switching transistor is electrically connected to an output terminal, a second electrode of the eighth switching transistor is electrically connected to the first voltage terminal, and a gate of the eighth switching transistor is electrically connected to the second node;
a ninth switching transistor, wherein a first electrode of the ninth switching transistor is electrically connected to a third voltage terminal, a second electrode of the ninth switching transistor is electrically connected to the fourth node, and a gate of the ninth switching transistor is electrically connected to a fifth node;
a tenth switching transistor, wherein a first electrode and a gate of the tenth switching transistor are electrically connected to the third voltage terminal, and a second electrode of the tenth switching transistor is electrically connected to the fifth node;
an eleventh switching transistor, wherein a first electrode of the eleventh switching transistor is electrically connected to the fourth node, a second electrode of the eleventh switching transistor is electrically connected to the first voltage terminal, and a gate of the eleventh switching transistor is electrically connected to the first node;
a twelfth switching transistor, wherein a first electrode of the twelfth switching transistor is electrically connected to the fifth node, a second electrode of the twelfth switching transistor is electrically connected to the first voltage terminal, and a gate of the twelfth switching transistor is electrically connected to the first node;
a thirteenth switching transistor, wherein a first electrode of the thirteenth switching transistor is electrically connected to the first node, a second electrode of the thirteenth switching transistor is electrically connected to the first voltage terminal, and a gate of the thirteen switching transistor is electrically connected to the fourth node;
a fourteenth switching transistor, wherein a first electrode of the fourteenth switching transistor is electrically connected to the output terminal, a second electrode of the fourteenth switching transistor is electrically connected to the first voltage terminal, and a gate of the fourteenth switching transistor is electrically connected to the fourth node;
a fifteenth switching transistor, wherein a first electrode of the fifteenth switching transistor is electrically connected to the first node, a second electrode of the fifteenth switching transistor is electrically connected to the first voltage terminal, and a gate of the fifteenth switching transistor is configured to receive a first reset signal;
a sixteenth switching transistor, wherein a first electrode of the sixteenth switching transistor is electrically connected to the output terminal, a second electrode of the sixteenth switching transistor is electrically connected to the first voltage terminal, and a gate of the sixteenth switching transistor is configured to receive a second reset signal;
a seventeenth switching transistor, wherein a first electrode of the seventeenth switching transistor is electrically connected to the first node, a second electrode of the seventeenth switching transistor is electrically connected to the first voltage terminal, and a gate of the seventeen switching transistor is configured to receive a global reset signal;
an eighteenth switching transistor, wherein a first electrode and a gate of the eighteenth switching transistor are configured to receive the first input signal, and a second electrode of the eighteenth switching transistor is electrically connected to the first node;
a nineteenth switching transistor, wherein a first electrode of the nineteenth switching transistor is configured to receive a second input signal, a second electrode of the nineteenth switching transistor is used as the output terminal, and a gate of the nineteenth switching transistor is electrically connected to the first node; and
a capacitor, wherein a first terminal of the capacitor is electrically connected to the first node, and a second terminal of the capacitor is electrically connected to the second electrode of the nineteenth switching transistor.

16. The gate driving circuit according to claim 15, **characterized in that**
the second voltage terminal is configured to provide a second level; and
the third voltage terminal is configured to provide the second level.

17. A display device, **characterized by** comprising: a plurality of gate driving circuits according to any one of claims 1 to 16;
wherein the plurality of gate driving circuits comprise N gate driving circuits, where N is a positive integer;
in the N gate driving circuits, the gate driving signal output by an (i-k)-th gate driving circuit is used as the first input signal of an i-th gate driving circuit, the gate driving signal output by an (i+k+1)-th gate driving circuit is used as the first reset signal of the i-th gate driving circuit, and the gate driving signal output by an (i+k)-th gate driving circuit is used as the second reset signal of the i-th gate driving circuit, where k+1≤i≤N-k-1 and i is a positive integer, 1≤k≤N-2 and k is a positive integer; and
in the N gate driving circuits, first input signals of first to k-th gate driving circuits are first input signals provided by an external circuit, first reset signals of (N-k)-th to N-th gate driving circuits are first reset signals provided by the external circuit, and second reset signals of (N-k+1)-th to N-th gate driving circuits are second reset signals provided by the external circuit.

18. A control method for a gate driving circuit, **characterized by** comprising:
changing a potential of a first node from a first level to a second level by an input sub-circuit under control of a first input signal;
outputting a gate driving signal in response to a second input signal by an output sub-circuit;
resetting a potential of an output terminal of the output sub-circuit by a second reset sub-circuit under control of a second reset signal; and
resetting the potential of the first node by a first reset sub-circuit under control of a first reset signal, and maintaining the potential of the first node and the potential of the output terminal of the output sub-circuit at the first level by at least one noise reduction sub-circuit;
wherein in the changing of the potential of the first node from the first level to the second level by the input sub-circuit, a function maintaining sub-circuit controls operation of the at least one noise reduction sub-circuit under control of the first input signal, so that the at least one noise reduction sub-circuit interrupts electrical coupling between the first node and a first voltage terminal.
